# EUROPÄISCHE PATENTSCHRIFT

(11) **EP 4 481 406 B1**
(45) Veröffentlichungstag und Bekanntmachung des Hinweises auf die Patenterteilung: **31.12.2025**
(21) Anmeldenummer: 24183029.8
(22) Anmeldetag: 19.06.2024
(51) Int. Cl.: G01R 27/18, G01R 31/52

(54) **VERFAHREN UND ELEKTRISCHE SCHALTUNGSANORDNUNG ZUR SELEKTIVEN ISOLATIONSÜBERWACHUNG IN EINEM STROMVERSORGUNGSSYSTEM MIT ABTRENNBAREN SUBSYSTEMEN**
METHOD AND ELECTRICAL CIRCUIT ARRANGEMENT FOR SELECTIVE INSULATION MONITORING IN A POWER SUPPLY SYSTEM WITH DISCONNECTABLE SUBSYSTEMS
PROCÉDÉ ET CIRCUIT ÉLECTRIQUE POUR LA SURVEILLANCE SÉLECTIVE DE L'ISOLATION DANS UN SYSTÈME D'ALIMENTATION ÉLECTRIQUE AVEC SOUS-SYSTÈMES SÉPARABLES

(30) Priorität: 23.06.2023 DE 102023116532
(43) Veröffentlichungstag der Anmeldung: 25.12.2024
(73) Patentinhaber: Bender GmbH & Co. KG, 35305 Grünberg (DE)
(72) Erfinder: HACKL, Dieter, 35463 Fernwald (DE)
(74) Vertreter: advotec.

(56) Entgegenhaltungen:
- EP-B1- 2 256 506
- EP-B1- 2 386 870
- EP-B1- 3 139 188

## Beschreibung

Die Erfindung betrifft ein Verfahren und eine elektrische Schaltungsanordnung zur selektiven Isolationsüberwachung in einem Stromversorgungssystem mit abtrennbaren Subsystemen, welche jeweils einen integrierten Energiespeicher aufweisen.

Um eine hohe Verfügbarkeit und Betriebssicherheit der elektrischen Stromversorgung sicherzustellen sowie die Personensicherheit im Aufenthaltsbereich elektrischer Anlagen zu gewährleisten, kommen in zunehmendem Maße Überwachungssysteme zum Einsatz, die Informationen über den Isolationszustand eines verzweigten Stromversorgungssystems in seiner Gesamtheit sowie über den Isolationszustand der angeschlossenen einzelnen Subsysteme liefern.

In Stromversorgungssystemen mit der Netzform IT-System (ungeerdetes Stromversorgungssystem) gibt ein Isolationsüberwachungsgerät nach dem Produktstandard IEC 61557-8 Auskunft über den Gesamtisolationswiderstand des Systems gegen Erde.

Nachdem in einem Stromversorgungssystem mit der Netzform IT-System mittels des Isolationsüberwachungsgerätes ein abgesunkener Gesamtisolationswiderstand erkannt wurde, kommen Isolationsfehlersuchsysteme nach dem Produktstandard IEC 61557-9 zum Einsatz, um einzelne fehlerhafte Subsysteme zu ermitteln. Das Isolationsfehlersuchsystem speist einen - von dem Messstrom des Isolationsüberwachungsgerätes unterschiedlichen - Lokalisierungsstrom in das Gesamtsystem ein, der zur Erkennung des fehlerhaften Subsystems von einem in diesem Subsystem installierten Stromsensor (Lokalisierungssensor) erfasst wird.

In Systemen mit einer geerdeten Netzform werden Differenzstromüberwachungssysteme nach dem Produktstandard IEC 62020-x eingesetzt, um den Isolationszustand von Subsystemen abzuschätzen.

Dabei können in sehr großen, weitverzweigten, zu überwachenden Stromversorgungssystemen und in Starkstromsystemen bei dem Einsatz bekannter marktverfügbarer Isolationsüberwachungssysteme die nachfolgend beschriebenen messtechnischen Probleme auftreten, für die bislang nur unzureichende Lösungen existieren.

Da Isolationsüberwachungssysteme den Gesamtisolationswiderstand aller galvanisch verbundenen Subsysteme als Parallelwiderstand aller ohmschen Ableitungen zwischen den aktiven Leitern und Erde ermitteln, kann dieser Wert bei einer Vielzahl von Subsystemen einen bedenklich niedrigen Isolationswiderstandswert von z.B. wenigen kOhm annehmen, obwohl der Isolationszustand jedes einzelnen Subsystems für den Betrieb, mit z.B. mehreren 100 kOhm, hinreichend hoch ist.

Die schleichende Degradation des Isolationszustandes eines fehlerhaften Subsystems kann auf alleiniger Basis der Isolationsüberwachung des Gesamtsystems - aufgrund der Parallelschaltung, die einen vielfach niedrigeren Gesamtisolationswiderstand ergibt - erst erkannt werden, wenn der Isolationszustand des fehlerhaften Subsystems schon weit unter einem für den Betrieb tolerierbaren Wert liegt.

Zudem reagieren gängige Isolationsfehlersuchsysteme in sehr weitläufigen, verzweigten IT-Systemen mit niedrigem Gesamtisolationswiderstandswert sehr unempfindlich, da sich der eingeprägte Lokalisierungsstrom auf sehr viele Subsysteme verteilt.

Um die Ansprechempfindlichkeit eines Lokalisierungssensors in einem Subsystem zu überschreiten, muss der Isolationsfehler in diesem Subsystem gegenüber dem Gesamtisolationswiderstand deutlich niederohmiger werden, wie folgendes Beispiel verdeutlicht:
Arbeitet ein Isolationsfehlersuchsystem mit 50mA Lokalisierungsstrom in einem IT-System mit 200 relativ identischen Subsystemen, so verbleiben pro Subsystem ca. 250µA Lokalisierungsstrom, den es zu erkennen gilt. Besitzt der Lokalisierungssensor eine Ansprechempfindlichkeit von 2mA, so muss ein fehlerhaftes Subsystem etwa einen um den Faktor 8 niedrigeren Isolationswiderstand als alle anderen Subsysteme besitzen, um einen Lokalisierungssensor zum Ansprechen zu bringen.

In IT-Systemen mit sehr großen Lastströmen werden die, meist differenzstrombasiert arbeitenden, Lokalisierungssensoren durch Sättigungseffekte im weichmagnetischen Material unempfindlicher. Degradationsvorgänge in einzelnen Subsystemen können erst detektiert werden, wenn diese bereits weit fortgeschritten sind.

In Systemen mit geerdeter Netzform und sehr großen Lastströmen werden die Differenzstromsensoren eines Differenzstromüberwachungssystems durch Sättigungseffekte im weichmagnetischen Material unempfindlicher. Auch hier können Degradationsvorgänge in einzelnen Subsystemen können erst in weit fortgeschrittenem Zustand erkannt werden.

Differenzstromüberwachungssysteme können prinzipbedingt keine symmetrischen Isolationsfehler erkennen.

Es ist daher geboten, den Isolationszustand von Subsystemen, auch in großen Gleich- und Wechselstromsystemen, mit geerdeter oder ungeerdeter Netzform, und auch unter Einfluss von großen Lastströmen, im Betrieb sehr sensitiv und annähernd kontinuierlich zu ermitteln.

Eine gemäß dem Stand der Technik gängige Praxis in IT-Systemen besteht darin, große zusammenhängende IT-Systeme zu vermeiden. Dies erfolgt mit Hilfe zusätzlicher Trenntransformatoren und ist in nachteiliger Weise mit hohen Kosten verbunden.

Für geerdet betriebene Stromversorgungssysteme sind aus dem Stand der Technik weitere Lösungsansätze zur Ermittlung des Isolationswiderstands bekannt.

Ein Ansatz zur selektiven Isolationsüberwachung von Subsystemen ist in der Patentschrift EP 2 851 692 B1 beschrieben. Dort ist in jedem Subsystem eine Differenzstrommesseinrichtung, ein Prüfsignalgenerator sowie eine Blockierungseinrichtung und eine selektive Entkopplungseinrichtung angeordnet. Der schaltungstechnische Aufwand ist in der Praxis so hoch, dass dieser Vorschlag bislang nicht zur Anwendung kommt.

In der Offenlegungsschrift EP 1 687 646 A1 wird aus einem Differenzstrom der durch das eingespeiste Gleichtakt-Spannungssignal erzeugte Differenzstrom-Messsignalanteil durch Filterung bestimmt und an der Messstelle das dort an den Netzleitern anstehende Gleichtakt-Spannungssignal gegen Erde erfasst. Aus dem so erfassten Gleichtakt-Spannungssignal wird der auf dem eingespeisten Gleichtakt-Spannungssignal beruhende Gleichtakt-Spannungssignalanteil durch Filterung bestimmt und der ohmsche Anteil des Isolationswiderstandes zwischen den Netzleitern und Erde wird durch Quotientenbildung zwischen dem momentanen Gleichtakt-Spannungssignalanteil an der Messstelle und dem momentanen Differenzstrom-Messsignalanteil an der Messstelle bestimmt.

In der Offenlegungsschrift DE 10 2018 121 979 A1 ist ein Verfahren zur Bestimmung eines Isolationswiderstands und zur Lokalisierung von Isolationsfehlern für ein Umrichter-gespeistes Stromversorgungssystem beschrieben. An dem Ausgang des Stromrichters wird dabei eine Gleichtaktspannung gegen Erde erzeugt, welche als aktive Messspannung dem ungeerdeten Netz zur Messung des Isolationswiderstands überlagert wird.

Das Dokument EP2256506 offenbart ein weiteres Verfahren zur selektiven Isolationsüberwachung in einem Stromversorgungssystem gemäß dem Stand der Technik.

Der schaltungstechnische Aufwand für die vorgenannten Verfahren und deren Umsetzung ist jedoch recht hoch, sodass sich diese Lösungsansätze bislang im Markt praktisch nicht durchsetzen konnten.

Ein weiterer Nachteil bei der Anwendung von Verfahren, die auf der Differenzstromüberwachungstechnologie basieren, besteht darin, dass die Überwachung von Subsystemen in weitverzweigten, geerdet betriebenen Starkstromsystemen oft nicht mit absoluten Grenzwerten, sondern mit einer Trendverfolgung erfolgt. In einem als "Gut" definierten Betriebszustand eines Subsystems wird ein Differenzstromwert als Referenzwert erfasst und ein ansteigender Differenzstrom in diesem Subsystem mit einem als kritisch definierten Delta-Differenzstromwert führt zu einer Alarmmeldung. Da gängige Differenzstromwandler physikalisch eine quadratische Summe aller Differenzstromanteile bilden, ist die erreichbare Sensitivität dieser Methode bei Subsystemen mit hohen Differenzstromwerten für den "Gut" Zustand nicht sehr hoch.

Auch Offline-Monitoring findet als Stand der Technik in Systemen mit geerdeter und ungeerdeter Netzform Verwendung.

Beim Offline-Monitoring werden einzelne Verbraucher im abgeschalteten Zustand isolationsüberwacht. Kennzeichnend für das Offline Monitoring ist, dass der überwachte Verbraucher sehr lange, d.h. über Stunden, Tage oder Monate hinweg, in dem abgeschalteten Zustand in Bereitschaft verharrt, denn alle Teile des offline-isolationsüberwachten Verbrauchers, die im aktiven Zustand mit aktiven Leitern galvanisch verbunden sind, müssen auch im abgeschalteten Stand-By Zustand über die Offline - Isolationsüberwachung galvanisch zugänglich sein. Beispiele hierfür sind Pumpenmotoren, Notfalltransformatoren oder Weichenheizsysteme.

Hinzu kommt, dass aktuell weit verbreitete Umrichtersysteme oder Schaltnetzteile nach dem Stand der Technik bislang nicht offlineisolationsüberwacht werden können.

Der vorliegenden Erfindung liegt somit die Aufgabe zu Grunde, für ein Stromversorgungssystem mit abtrennbaren Subsystemen, welche voraussetzungsgemäß jeweils einen integrierten Energiespeicher aufweisen, ein Verfahren und eine elektrische Schaltungsanordnung zu entwerfen, welche eine für alle Netzformen einsetzbare, selektiv jeweils auf das einzelne Subsystem bezogene, Isolationsüberwachung erlauben und zugleich schaltungstechnische Ressourcen schonen sowie aktuelle technologische Entwicklungen berücksichtigen.

Diese Aufgabe wird in einem Verfahren mit folgenden Verfahrensschritten gelöst: zyklisches, kurzzeitiges Trennen des zu überwachenden Subsystems jeweils für die Dauer eines Mess-Zeitintervalls mit allpoligen Halbleiter-Trennschaltern, Weiterbetreiben des getrennten zu überwachenden Subsystems mittels seines integrierten Energiespeichers während des Mess-Zeitintervalls und Messen eines Isolationswiderstands des Subsystems während des Mess-Zeitintervalls mittels eines normgemäßen Isolationsüberwachungsgerätes.

Als systemtechnische Voraussetzung für die Anwendung des erfindungsgemäßen Verfahrens wird davon ausgegangen, dass das Stromversorgungssystem unabhängig von der geerdeten oder ungeerdeten Netzform abtrennbare Subsysteme mit jeweils mindestens einem integrierten Energiespeicher aufweist. Dabei soll der Energiespeicher voraussetzungsgemäß so ausgestaltet sein, dass er für einen kurzen Zeitraum (Mess-Zeitintervall) einen ungestörten Weiterbetrieb des zu überwachenden Subsystems ermöglicht.

Durch den im Zuge der technologischen Entwicklung aktuell zunehmenden Einsatz von Umrichter-gesteuerten Systemen und Schaltnetzteilen mit inhärenten Energiespeichern ist die Voraussetzung eines ununterbrochenen Weiterbetriebs für einen hinreichend kurzen Zeitraum meistens erfüllt.

Unter "kurzzeitig" bzw. "einem kurzem Zeitraum" ist dabei eine Zeitdauer zu verstehen, die auf die Norm EN 50160 Bezug nimmt, welche die nach aktuellem technischen Stand zu erwartende Auslegung von Betriebsmitteln im Hinblick auf die Spannungsqualität beschreibt, insbesondere auf die Dauer von Spannungseinbrüchen. Dabei kann hier als Mess-Zeitintervall eine Dauer von <1s angenommen werden, innerhalb der die Betriebsmittel ohne Einschränkung weiter funktionieren.

Darauf aufbauend besteht der Grundgedanke der vorliegenden Erfindung darin, durch zyklisches Abtrennen für jeweils ein Mess-Zeitintervall das zu überwachende Subsystem zu isolieren, zugleich aber mittels des eigenen Energiespeichers weiter zu betreiben und während des Mess-Zeitintervalls eine Isolationswiderstandsmessung durchzuführen. Die Isolationswiderstandsmessung kann abhängig von dem angewandten Messverfahren innerhalb eines Mess-Zeitintervalls abgeschlossen sein oder sich über eine Abfolge von Mess-Zeitintervallen erstrecken (siehe unten).

Die erfindungsgemäße Lösung basiert damit auf der Kombination von
a) einer zyklischen Trennung des zu überwachenden Subsystems vom Gesamt-Stromversorgungssystem jeweils für die Dauer eines Mess-Zeitintervalls,
b) der Eigenschaft des Subsystems, dass es während des Mess-Zeitintervalls operativ ungestört aus den (eigenen) im Subsystem vorhandenen Energiespeichern weiterbetrieben werden kann und
c) einem Isolationsüberwachungssystem (Isolationsüberwachungsgerät nach IEC 61557-8), welches im abgetrennten Zustand des Subsystems aktiv und normgerecht innerhalb des Mess-Zeitintervalls den Isolationswiderstand des Subsystems im Betriebszustand ermittelt.

In vorteilhafter Weise wird ein schaltungstechnische Ressourcenschonendes, Bauraum-sparendes sowie kostengünstiges und für alle Netzformen umsetzbares Verfahren zu Subsystem-selektiven Isolationsüberwachung geschaffen, das auch aktuelle technologische Entwicklungen, insbesondere unter Berücksichtigung von Umrichter-Architekturen, miteinbezieht.

Es entfällt beispielsweise die Notwendigkeit, für jedes zu überwachende Subnetz einen zusätzlichen Differenzstromwandler für die Isolationsfehlersuche oder die Differenzstromüberwachung zu installieren.

Da diese Komponenten meist beachtliche Mengen weichmagnetisches Material enthalten, sind sie teuer, benötigen viel Bauraum bei der Installation und sind nur relativ energieaufwändig herstellbar.

Im Vergleich dazu kann das erfindungsgemäße Verfahren mit einem kostenoptimierten integrierten Schaltkreis wirtschaftlich, Bauraumneutral und mit kleinem ökologischem Fußabdruck umgesetzt werden.

In weiterer vorteilhafter Ausgestaltung erfolgt das Messen mit einem Messverfahren, das innerhalb genau eines Mess-Zeitintervalls oder in einer zyklischen Abfolge von mehreren Mess-Zeitintervallen eine hinreichend zuverlässige Bestimmung des Isolationswiderstands erlaubt.

Es gelangen somit Messverfahren zur Anwendung, die entweder synchron innerhalb genau eines Mess-Zeitintervalls eine hinreichend genaue Voraussage über den tatsächlichen Isolationswiderstand des Subsystems liefern, oder das Messverfahren ist zyklisch während einer Abfolge von mehreren aufeinanderfolgenden Mess-Zeitintervallen synchron mit der Taktung des Abtrennvorgangs aktiv, um innerhalb mehrerer Zyklen den Isolationswiderstand zu bestimmen oder dessen Bestimmung zu optimieren.

Bevorzugt wird als Messverfahren ein Impuls-Messverfahren mit Auswertung einer durch eine Kapazitätsaufladung in dem Subsystem bestimmten Zeitkonstanten implementiert.

Eine von einem Messimpulsgenerator des Isolationsüberwachungsgerätes dem Stromversorgungssystem überlagerte, getaktete Messspannung nach dem Impuls-Messverfahren ermöglicht die Auswertung einer kapazitätsaufladenden e-Funktion (natürliche Exponentialfunktion). Auf Basis der daraus abgeleiteten Zeitkonstanten können vorausschauend während der Aufladung bzw. Entladung der Subsystem-Netzkapazitäten wichtige Erkenntnisse über den Isolationszustand des Subsystems gewonnen werden (Sub-Tau-Verfahren).

Mit Vorteil werden Halbleiter-Trennschalter mit hinreichend hochohmiger Trenneigenschaft verwendet.

Die zunehmende Verbreitung von Halbleiterschaltern, welche Trenneigenschaften besitzen und sehr schnell nahezu ohne Begrenzung der Schaltanzahl ein Subsystem zyklisch für jeweils ein Mess-Zeitintervall vom Hauptsystem isolieren können, eröffnet die Möglichkeit einer schaltungstechnisch einfachen und ökonomisch realisierbaren Subsystem-Isolationsüberwachung.

Die Trenneigenschaften des Halbleiterschalters müssen hinreichend hochohmig sein, um den Dynamikbereich des Isolationsüberwachungssystems nicht zu beschränken. Anzustreben sind Isolationszustände im MOhm Bereich.

Weiterhin kann, falls die Halbleiter-Trennschalter keine hinreichend hochohmige Trenneigenschaft aufweisen, ein Grundisolationswert bei der Bestimmung des Isolationswiderstands berücksichtigt werden.

Ist die Voraussetzung einer hinreichend hochohmigen Trenneigenschaft nicht erfüllbar, sollte der Einfluss des begrenzten Isolationsvermögens der Halbleiter-Trennschalter auf die Subsystem-Isolationsüberwachung in der Mess- und Bewertungsmethode berücksichtigt werden. Beispielsweise könnte die Isolationsüberwachung eines Subsystems nach einem Halbleiter-Gleichrichter (siehe unten) synchron zur Netzfrequenz in Zeiten erfolgen, in denen kein Laststromfluss erfolgt. Die ohmschen Leckströme des Halbleiter-Gleichrichters müssten dann als parallelgeschalteter, systembedingter Grundisolationswert bei der Ermittlung des Isolationswiderstands des Subsystems berücksichtigt werden.

Mit Vorteil wird ein Halbleiter-Gleichrichter als Halbleiter-Trennschalter verwendet.

Mittels einer Gleichrichterschaltung können in Abhängigkeit eines Schwellwertes Durchlass- und Sperrphasen zur Steuerung der Dauer des Mess-Zeitintervalls bestimmt werden. Da das verfügbare Mess-Zeitintervall in diesem Fall deutlich kürzer ist, erstreckt sich die Bestimmung des Isolationswiderstands über mehrere Mess-Zeitintervalle, wobei geeignete, von dem Impuls-Messverfahren abweichende Messverfahren zur Anwendung gelangen.

Bevorzugt werden bei dem Einsatz eines Umrichtersystems in dem Subsystem umrichtereigene Energiespeicher und/oder bei der Verwendung von Schaltnetzteilen deren Energiespeicher verwendet.

Durch den im Zuge der technologischen Entwicklung aktuell zunehmenden Einsatz von Umrichter-gesteuerten Systemen und Schaltnetzteilen mit inhärenten Energiespeichern kann die Voraussetzung eines ununterbrochenen Weiterbetriebs für einen hinreichend kurzen Zeitraum in den meisten Fällen erfüllt werden.

Die beanspruchten strukturellen Merkmale der erfindungsgemäßen elektrischen Schaltungsanordnung führen die entsprechenden Verfahrensschritte des erfindungsgemäßen Verfahrens aus. Somit treffen die mit dem Verfahren erzielten technischen Wirkungen und die daraus resultierenden Vorteile gleichermaßen auch auf die erfindungsgemäße elektrische Schaltungsanordnung zu.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
- **Fig. 1:**: ein erfindungsgemäßes Verfahren,
- **Fig. 2:**: ein funktionales Blockschaltbild einer erfindungsgemäßen elektrischen Schaltungsanordnung in einem 3AC-Stromversorgungssystem,
- **Fig. 3:**: ein funktionales Blockschaltbild einer erfindungsgemäßen elektrischen Schaltungsanordnung in einem DC-Stromversorgungssystem und
- **Fig. 4:**: ein funktionales Blockschaltbild einer erfindungsgemäßen elektrischen Schaltungsanordnung in einem 3AC-Stromversorgungssystem mit Halbleiter-Gleichrichter.

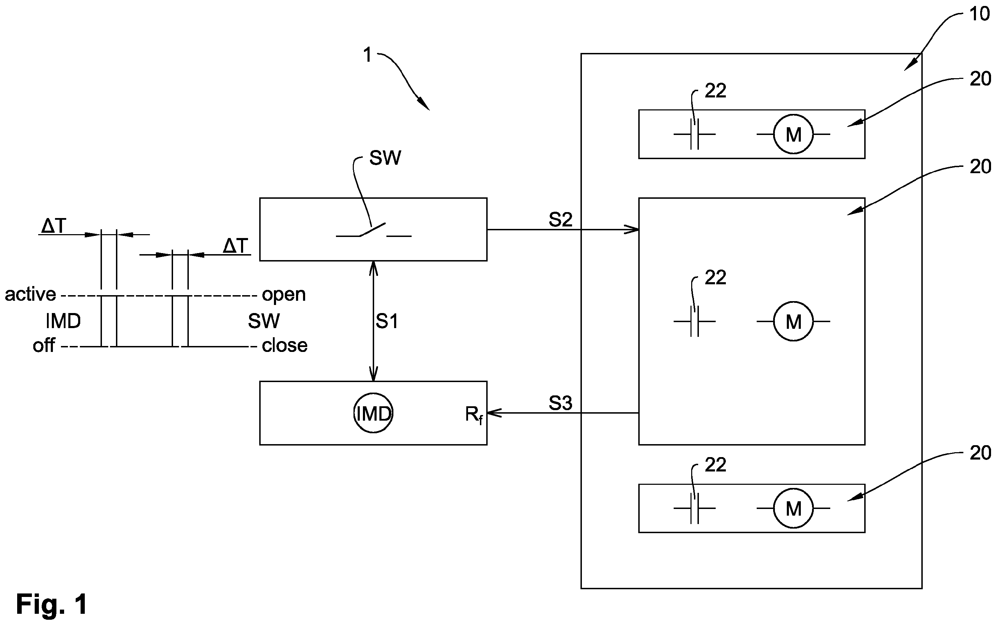

**Fig. 1** zeigt ein erfindungsgemäßes Verfahren 1 in Verbindung mit einem zu überwachenden Subsystem 20 eines aus mehreren Subsystemen 20 bestehenden Stromversorgungssystems 10.

In dieser Darstellung erfolgt in Schritt S1 ein zyklisches, kurzzeitiges Trennen des zu überwachenden Subsystems 20 jeweils für die Dauer eines Mess-Zeitintervalls ΔT mittels allpoliger Halbleiter-Trennschalter SW.

Während des Mess-Zeitintervalls ΔT befinden sich die Halbleiter-Trennschalter SW in geöffnetem Zustand und das so abgetrennte Subsystem 20 wird gemäß Schritt S2 operativ ungestört aus den in diesem Subsystem 20 vorhanden Energiespeichern 22 weiterbetrieben.

Gleichzeitig ist gemäß Schritt S3 während des Mess-Zeitintervalls ΔT ein Isolationsüberwachungsgerät IMD aktiv, um innerhalb des Mess-Zeitintervalls ΔT den Isolationswiderstand R_{f} des abgetrennten Subsystems 20 zu bestimmen oder die Messung des Isolationswiderstands R_{f} fortzusetzen und damit fortlaufend die Genauigkeit der Isolationswiderstandsüberwachung zu erhöhen.

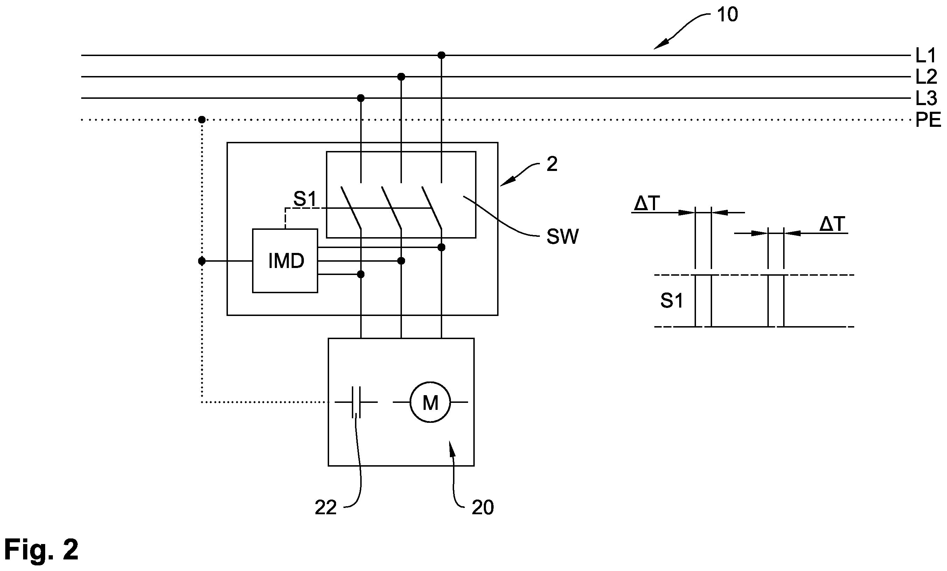

In **Fig. 2** ist ein funktionales Blockschaltbild einer erfindungsgemäßen elektrischen Schaltungsanordnung 2 in einem 3AC-Stromversorgungssystem 10 dargestellt. Das 3AC-Stromversorgungssystem 10 umfasst aktive Leiter L1, L2, L3 und einen Schutzleiter (Erde) PE. Voraussetzungsgemäß ist an dieses Stromversorgungssystem 10 das Subsystem 20 mit Energiespeichern 22 angeschlossen.

Die erfindungsgemäße elektrische Schaltungsanordnung 2 umfasst ein nach der Norm IEC 61557-8 ausgeführtes Isolationsüberwachungsgerät IMD, welches zwischen die aktiven Leiter L1, L2, L3 des Subsystems 20 und Erde PE angeschlossen ist, sowie die allpoligen Halbleiter-Trennschalter SW.

Die Halbleiter-Trennschalter SW trennen das zu überwachende Subsystem 20 zyklisch für die Dauer des Mess-Zeitintervalls ΔT von dem Hauptsystem (Schritt S1), wobei - angedeutet durch die mit S1 bezeichnete Verbindung zwischen den Halbleiter-Trennschaltern SW und dem Isolationsüberwachungsgerät IMD - synchron zu dem Schaltzustand der Halbleiter-Trennschalter SW während des Mess-Zeitintervalls ΔT eine Messung des Isolationswiderstands R_{f} des Subsystems 20 durchgeführt wird.

Mit den in dem Subsystem 20 vorhandenen Energiespeichern 22 ist ein kontinuierlicher Betrieb des Subsystems 20 auch während der Mess-Zeitintervalle ΔT im abgetrennten Zustand gewährleistet (Schritt S3, Fig. 1).

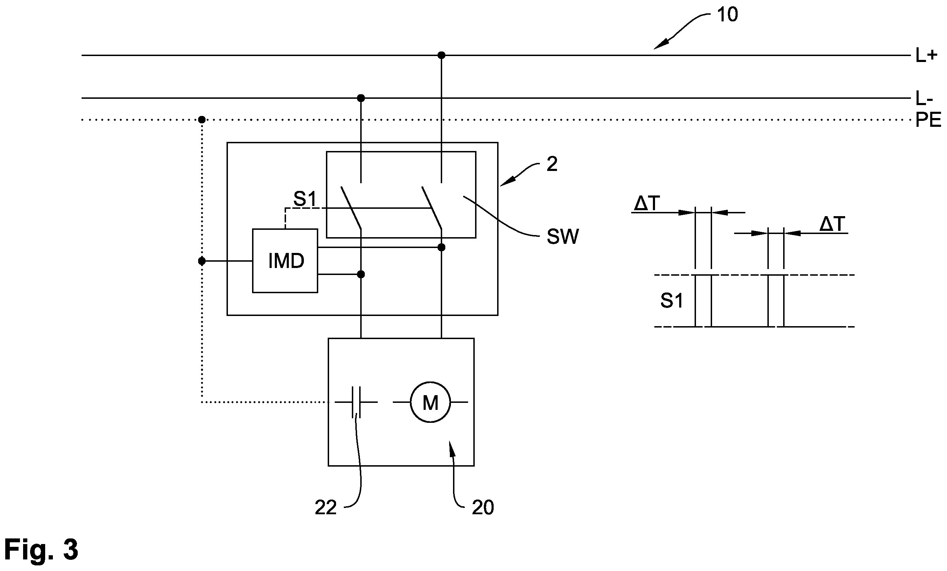

**Fig. 3** zeigt die elektrische Schaltungsanordnung 2 in einem DC-Stromversorgungssystem 10 mit aktiven Leitern L+, L-. Der Unterschied zu der in Fig. 2 beschriebenen Anordnung besteht lediglich in der zweipoligen Ankopplung des Isolationsüberwachungsgerätes IMD und der zweipoligen Ausführung der Halbleiter-Trennschalter SW.

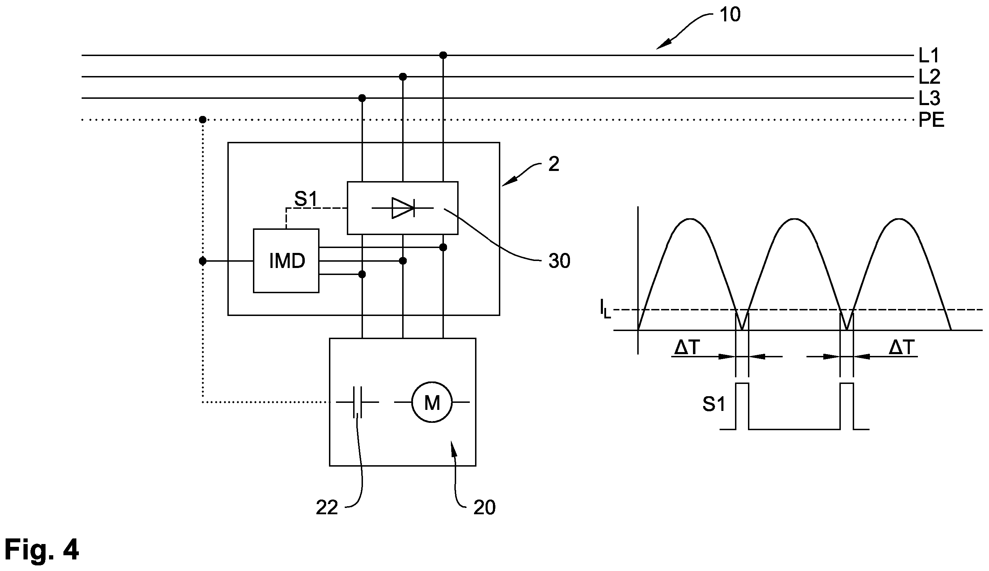

Die Darstellung in **Fig. 4** beruht auf der Anordnung in Fig. 2 zur Isolationsüberwachung in einem 3AC-Stromversorgungssystem 10. Als allpoliger Halbleiter-Trennschalter SW ist hier ein Halbleiter-Gleichrichter 30 installiert. Unterhalb eines festzulegenden Laststrom-Schwellwertes I_{L} kann das Subsystem 20 als abgetrennt betrachtet werden, sodass während dieser Mess-Zeitintervalle ΔT, in denen kein oder nur ein geringer Laststromfluss vorliegt, das Isolationsüberwachungsgerät IMD aktiviert ist. Die während der Mess-Zeitintervalle ΔT fließenden ohmschen Leckströme des Halbleiter-Gleichrichters werden bei der Ermittlung des Isolationswiderstands R_{f} des Subsystems 20 berücksichtigt.

## Patentansprüche

1. Verfahren (1) zur selektiven Isolationsüberwachung in einem Stromversorgungssystem (10) mit abtrennbaren Subsystemen (20), welche jeweils einen integrierten Energiespeicher (22) aufweisen, umfassend die Verfahrensschritte:
Zyklisches, kurzzeitiges Trennen (S1) des zu überwachenden Subsystems (20) jeweils für die Dauer eines Mess-Zeitintervalls (ΔT) mit allpoligen Halbleiter-Trennschaltern (SW),
Weiterbetreiben (S2) des getrennten zu überwachenden Subsystems (20) mittels seines integrierten Energiespeichers (22) während des Mess-Zeitintervalls (ΔT),
Messen (S3) eines Isolationswiderstands (R_{f}) des Subsystems (20) während des Mess-Zeitintervalls (ΔT) mittels eines normgemäßen Isolationsüberwachungsgerätes (IMD).

2. Verfahren nach Anspruch 1,
**dadurch gekennzeichnet,**
**dass** das Messen (S3) mit einem Messverfahren erfolgt, das innerhalb genau eines Mess-Zeitintervalls (ΔT) oder in einer zyklischen Abfolge von mehreren Mess-Zeitintervallen (ΔT) eine hinreichend zuverlässige Bestimmung des Isolationswiderstands (R_{f}) erlaubt.

3. Verfahren nach Anspruch 1 oder 2,
**dadurch gekennzeichnet,**
**dass** als Messverfahren ein Impuls-Messverfahren mit Auswertung einer durch eine Kapazitätsaufladung in dem Subsystem (20) bestimmten Zeitkonstanten implementiert wird.

4. Verfahren nach einem der Ansprüche 1 bis 3,
**gekennzeichnet durch**
die Verwendung von Halbleiter-Trennschaltern (SW) mit hinreichend hochohmiger Trenneigenschaft.

5. Verfahren nach einem der Ansprüche 1 bis 4,
**dadurch gekennzeichnet,**
**dass**, falls die Halbleiter-Trennschalter (SW) keine hinreichend hochohmige Trenneigenschaft aufweisen, ein Grundisolationswert bei der Bestimmung des Isolationswiderstands (R_{f}) berücksichtigt wird.

6. Verfahren nach einem der Ansprüche 1 bis 5,
**dadurch gekennzeichnet,**
**dass** bei dem Einsatz eines Umrichtersystems in dem Subsystem (20) umrichtereigene Energiespeicher (22) und/oder bei der Verwendung von Schaltnetzteilen deren Energiespeicher (22) verwendet werden.

7. Verfahren nach einem der Ansprüche 1 bis 2,
**dadurch gekennzeichnet,**
**dass** ein Halbleiter-Gleichrichter (30) als Halbleiter-Trennschalter (SW) verwendet wird.

8. Elektrische Schaltungsanordnung (2) zur selektiven Isolationsüberwachung in einem Stromversorgungssystem (10) mit abtrennbaren Subsystemen (20), welche jeweils einen integrierten Energiespeicher (22) aufweisen, mit
allpoligen Halbleiter-Trennschaltern (SW) zum zyklischen, kurzzeitigen Trennen (S1) des zu überwachenden Subsystems (20) jeweils für die Dauer eines Mess-Zeitintervalls (ΔT), wobei das getrennte zu überwachende Subsystem (20) mittels seines integrierten Energiespeichers (22) während des Mess-Zeitintervalls (ΔT) weiterbetrieben (S2) wird, und mit
einem normgemäßen Isolationsüberwachungsgerät (IMD) zum Messen (S3) eines Isolationswiderstands (R_{f}) des Subsystems (20) während des Mess-Zeitintervalls (ΔT).

9. Elektrische Schaltungsanordnung (2) nach Anspruch 8,
**dadurch gekennzeichnet,**
**dass** die Halbleiter-Trennschalter (SW) eine hinreichend hochohmige Trenneigenschaft aufweisen.

## Claims

1. A method (1) for selective insulation monitoring in a power supply system (10) having isolable subsystems (20) which each has an integrated energy storage (22), the method comprising the following steps:
cyclic, temporary isolation (S1) of the subsystem (20) to be monitored for the duration of a measuring interval (ΔT) with all-pole semiconductor disconnectors (SW),
continued operation (S2) of the isolated subsystem to be monitored (20) by means of its integrated energy storage (22) during the measuring interval (ΔT),
measuring (S3) an insulation resistance (R_{f}) of the subsystem (20) during the measuring interval (ΔT) by means of a standardized insulation monitoring device (IMD).

2. The method according to claim 1,
**characterized in that**
the measurement (S3) is implemented using a measuring method which allows a sufficiently reliable determination of the insulation resistance (R_{f}) within precisely one measuring interval (ΔT) or in a cyclic sequence of several measuring intervals (ΔT).

3. The method according to claim 1 or 2,
**characterized in that**
the implemented measuring method is a pulse measuring method with an evaluation of a time constant determined in the subsystem (20) by a capacitance charge.

4. The method according to any one of the claims 1 to 3,
**characterized by**
the use of semiconductor disconnectors (SW) having sufficiently high-impedance isolation properties.

5. The method according to any one of the claims 1 to 4,
**characterized in that**
should the semiconductor disconnectors (SW) not have sufficiently high-impedance isolation properties, a basic insulation value is taken into consideration when determining the insulation resistance (R_{f}).

6. The method according to any one of the claims 1 to 5,
**characterized in that**
the convertor's energy storage (22) is used when using a convertor system in the subsystem (20) and/or the switching power supply's energy storage (22) is used when using switching power supplies.

7. The method according to claim 1 to 2,
**characterized in that**
a semiconductor rectifier (30) is used as the semiconductor disconnector (SW).

8. An electric circuit arrangement (2) for selective insulation monitoring in a power supply system (10) having isolable subsystems (20) which each has an integrated energy storage (22), the electric circuit arrangement (2) having
all-pole semiconductor disconnectors (SW) for cyclic, temporary isolation (S1) of the subsystem to be monitored (20) for the duration of a measuring interval (ΔT), operation of the isolated subsystem (20) to be monitored being continued (S2) by means of its integrated energy storage (22) during the measuring interval (ΔT), and having
a standard insulation monitoring device (IMD) for measuring (S3) an insulation resistance (R_{f}) of the subsystem (20) during the measuring interval (ΔT).

9. The electric circuit arrangement (2) according to claim 8, **characterized in that**
the semiconductor disconnectors (SW) have a sufficiently high-impedance isolation property.

## Revendications

1. Procédé (1) pour la surveillance sélective de l'isolation dans un système (10) d'alimentation en énergie comportant des sous-systèmes (20) isolables qui comportent chacun un stockage d'énergie électrique (22) intégré, le procédé comprenant les étapes suivantes :
l'isolation (S1) cyclique et temporaire du sous-système (20) à surveiller pendant la durée d'un intervalle de temps de mesure (ΔT) à l'aide de sectionneurs à semi-conducteurs (SW) omnipolaires,
l'opération continue (S2) du sous-système (20) isolé à surveiller au moyen de son stockage de l'énergie électrique (22) intégré pendant l'intervalle (ΔT) de temps de mesure,
la mesure (S3) d'une résistance d'isolement (R_{f} ) du sous-système (20) pendant l'intervalle de temps de mesure (ΔT) au moyen d'un dispositif normalisé (IMD) de surveillance d'isolement.

2. Procédé selon la revendication 1,
**caractérisé en ce que**
la mesure (S3) est mise en œuvre à l'aide d'un procédé de mesure qui permet une détermination suffisamment fiable de la résistance d'isolement (R_{f}) dans un intervalle (ΔT) de temps de mesure exactement ou dans une séquence cyclique de plusieurs intervalles de temps de mesure (ΔT).

3. Procédé selon la revendication 1 ou la revendication 2,
**caractérisé en ce que**
le procédé de mesure mis en œuvre est un procédé de mesure d'impulsions avec une évaluation d'une constante de temps déterminée dans le sous-système (20) par un chargement de capacité.

4. Procédé selon l'une quelconque des revendications 1 à 3,
**caractérisé par**
l'utilisation de sectionneurs à semi-conducteurs (SW) ayant des propriétés d'isolation à impédance suffisamment élevée.

5. Procédé selon l'une quelconque des revendications 1 à 4,
**caractérisé en ce que**
si les sectionneurs à semi-conducteurs (SW) n'ont pas des propriétés d'isolation à impédance suffisamment élevée, une valeur d'isolement de base est prise en considération lors de la détermination de la résistance d'isolement (R_{f}).

6. Procédé selon l'une quelconque des revendications 1 à 5,
**caractérisé en ce que**
le stockage de l'énergie électrique (22) du convertisseur est utilisé lors de l'utilisation d'un système de convertisseur dans le sous-système (20) et/ou le stockage de l'énergie électrique (22) de l'alimentation à découpage est utilisé lors de l'utilisation d'une alimentation à découpage.

7. Procédé selon la revendication 1 à 2,
**caractérisé en ce**
**qu'**un redresseur à semi-conducteur (30) est utilisé comme sectionneur à semi-conducteur (SW).

8. Agencement de circuit électrique (2) pour la surveillance sélective de l'isolement dans un système (10) d'alimentation en énergie comportant des sous-systèmes (20) isolables qui comportent chacun un stockage d'énergie électrique (22) intégré, l'agencement de circuit électrique (2) comportant
des sectionneurs à semi-conducteurs (SW) omnipolaires pour l'isolation (S1) cyclique et temporaire du sous-système (20) à surveiller pendant la durée d'un intervalle (ΔT) de temps de mesure, l'opération du sous-système (20) isolé à surveiller étant continue (S2) au moyen de son stockage de l'énergie électrique (22) intégré pendant l'intervalle (ΔT) de temps de mesure, et ayant
un dispositif normalisé (IMD) de surveillance d'isolement pour mesurer (S3) une résistance d'isolement (R_{f}) du sous-système (20) pendant l'intervalle (ΔT) de temps de mesure.

9. Agencement de circuit électrique (2) selon la revendication 8, **caractérisé en ce que**
les sectionneurs à semi-conducteurs (SW) ont une propriété d'isolation à impédance suffisamment élevée.
